Europäisches Patentamt

European Patent Office

Office européen des brevets

(19)

(11) Numéro de publication: **0 006 787**
**B1**

(12) **FASCICULE DE BREVET EUROPEEN**

(45) Date de publication du fascicule de brevet: **15.04.81**

(51) Int. Cl.³: **G 03 B 41/00**

(21) Numéro de dépôt: **79400372.3**

(22) Date de dépôt: **08.06.79**

(54) Système optique de projection muni d'un positionneur de plaque.

(30) Priorité: **23.06.78 FR 7818835**

(43) Date de publication de la demande:
**09.01.80 Bulletin 80/1**

(45) Mention de la délivrance du brevet:
**15.04.81 Bulletin 81/15**

(84) Etats Contractants Désignés:
**DE GB IT NL**

(56) Documents cités:
**DE - A - 1 614 041**
**GB - A - 1 324 810**
**US - A - 3 705 769**
**US - A - 3 858 978**

(73) Titulaire: **THOMSON-CSF**
**173, Boulevard Haussmann**
**F-75360 Paris Cedex 08 (FR)**

(72) Inventeur: **Lacombat, Michel**
**"THOMSON-CSF" - SCPI 173, bld Haussmann**
**F-75360 Paris Cedex 08 (FR)**
Inventeur: **Graffin, Jean-Claude**
**"THOMSON-CSF" - SCPI 173, bld Haussmann**
**F-75360 Paris Cedex 08 (FR)**
Inventeur: **Antoine, Robert**
**"THOMSON-CSF" - SCPI 173, bld Haussmann**
**F-75360 Paris Cedex 08 (FR)**

(74) Mandataire: **Desperrier, Jean-Louis et al,**
**"Thomson-CSF" - SCPI 173, Bld Haussmann**
**F-75360 Paris Cedex 08 (FR)**

Courier Press, Leamington Spa, England.

Système optique de projection muni d'un positionneur de plaque

La présente invention se rapporte aux systèmes optiques de projection munis de positionneurs de plaques. De tels systèmes optiques comprennent au moins un objectif destiné soit à projeter une image sur la plaque disposée par le positionneur, soit au contraire à former une image d'un motif porté par cette plaque sur un écran de visualisation par exemple.

Une réalisation particulière d'un tel système optique, appelée photo-répéteur, permet de projeter l'image en réduction d'un motif sur un grand nombre de plages adjacentes d'une couche photosensible déposée sur la surface plane d'une telle plaque. Le niveau de précision désiré étant de l'ordre du micromètre, il est nécessaire de positionner cette plaque par rapport à l'objectif, tant en distance qu'en assiette, avec une précision du même ordre. Un positionneur permettant d'obtenir ce résultat est décrit dans la demande de brevet français N° 77.11 909 intitulée "Platine à rattrapage de niveau et positionneur à indexation mècanique utilisant une telle platine" et déposée le 20 Avril 1977 au nom de la demanderesse. Ce positionneur comprend une rotule permettant un réglage tant en distance qu'en assiette, et un volet basculant. Dans une position de réglage ce volet basculant définit le plan de positionnement de la plaque. Celle-ci est alors serrée par sa face sensible contre le volet par la rotule qui est ensuite bloquée dans la position définie par ce serrage. Le volet bascule alors dans une deuxième position, ce qui démasque la face sensible ainsi placée dans le plan de positionnement.

Un tel volet basculant constitue une pièce intermédiaire qui n'est pas directement liée à l'objectif de projection et qui peut prendre avec le temps autour de son axe de basculement un jeu qui, même minime, fausse le résultat.

Par ailleurs, le volet appuie par toute sa surface sur la couche sensible, d'où un risque de détérioration accru de cette dernière.

Enfin, il est nécessaire de respecter une procèdure stricte d'utilisation pour ne détériorer ni la plaque, ni surtout les éléments du photo-composeur.

L'invention propose de remédier à ces inconvénients en utilisant un ensemble de vérins solidaires de la couronne de l'objectif et dont les extrémités déterminent dans une position de réglage le plan de référence souhaité. Une rotule adéquate, par exemple du type cité plus haut, permet de presser la plaque sensible contre ces vérins. La rotule est alors bloquée et les vérins rétractés. Les différents circuits de commande sont reliés par des éléments logiques qui interdisent les fausses manoeuvres.

D'autres particularités et avantages de l'invention apparaitront clairement dans la description suivante présentée à titre d'exemple non limitatif et faite en regard des figures annexées qui représentent:

— la figure 1, une vue partielle et schématique d-un photo-répéteur;

— la figure 2, une monture d'objectif munie de vérins de référence;

— la figure 3, une vue en coupe d'un de ces vérins;

— la figure 4, une vue en plan d'une table porteplaque;

— la figure 5, le schéma d'un dispositif de commande fluidique et électrique.

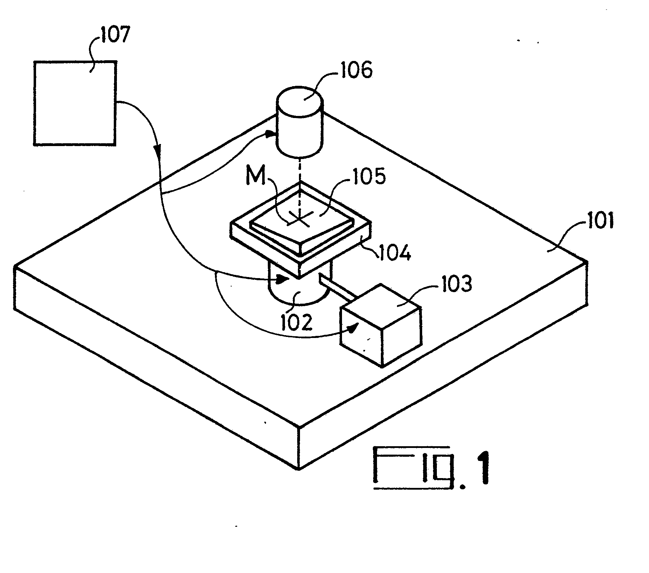

Le photo-répéteur représenté de manière schématique et partielle en figure 1 comprend un plateau 101 déterminant un premier plan de référence. Sur ce plateau, une rotule 102 peut se déplacer en tous sens sous l'action d'un mécanisme de déplacement 103. Cette rotule est par exemple du type décrit dans notre demande de brevet N° 77.11 909 citée ci-dessus. Elle porte une table 104 qui elle-même porte une plaque sensible 105. Les deux surfaces opposées d'une telle plaque sont polies et sensiblement parallèles, mais on n'a poussé le polissage au degré souhaité que sur une seule de ces faces et il n'est pas possible de garantir la précision du parallélisme de l'autre face par rapport à celle-ci dans la même mesure, ni l'épaisseur de la plaque. C'est cette face particulièrement soignée qui reçoit une couche sensible et la plaque repose sur la table 104 par l'autre face.

Le photo-répéteur comprend par ailleurs des moyens de projection dont on n'a représenté qu'un objectif de projection 106 et qui sont fixés de manière précise et rigide par rapport au plateau 101 de manière à projeter un motif, représenté ici par une croix, dans un deuxième plan de référence rigoureusement parallèle au premier plan de référence et situé à une distance déterminée et fixe de celui-ci.

Pour que ce motif soit projeté sur la face sensible de la plaque 105 et qu'il y reste durant les déplacements de l'ensemble rotule-table-plaque sur le plateau 101, il faut placer lors d'un réglage initial cette face sensible dans ce deuxième plan. C'est le rôle de la rotule 102 qui corrige les erreurs d'épaisseur et de parallélisme de la plaque 105 sous la commande d'un boîtier de commande 107 qui commande également les mouvements du mécanisme 103, ainsi que les vérins de positionnement définis ci-dessous.

Pour faire fonctionner la rotule 102 il est nécessaire de définir par des organes mécaniques le deuxième plan de référence. Ainsi la rotule vient d'abord plaquer dans un mouvement ascendant la face sensible de la plaque 105 contre ces organes mécaniques. Ensuite on bloque la rotule dans la position où elle s'est arrêtée, ce qui immobilise l'ensemble rotule-table-plaque et ainsi la surface sensible reste fixée dans le deuxième plan de référence.

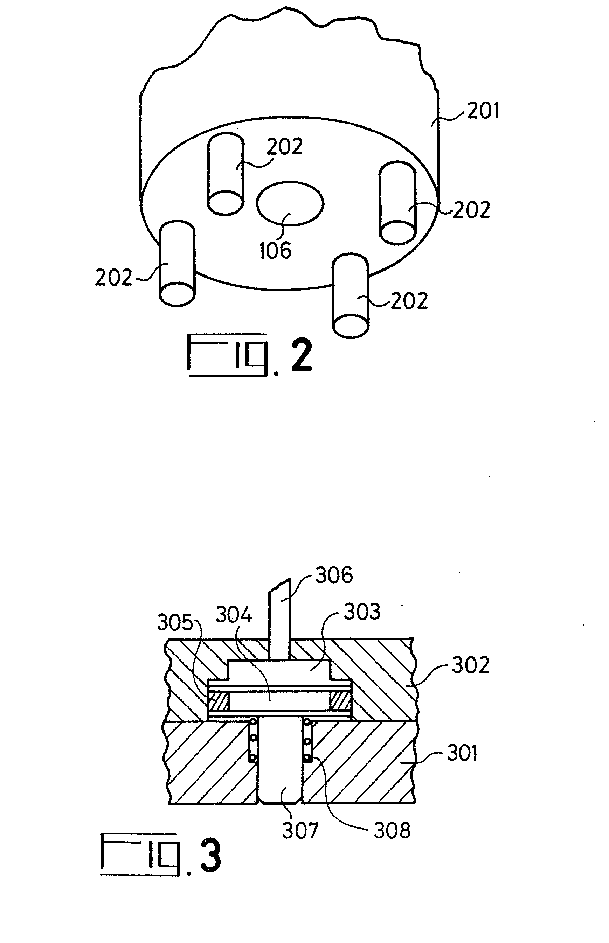

On montre sur la figure 2 une vue partielle de la monture 201 de l'objectif 106. Sur le pourtour de cette monture, on a disposé un ensemble de vérins 202 qui peuvent se rétracter dans la monture ou se déployer au dehors. Dans la position déployée qui est celle de la figure, les extrémités de ces vérins définissent le deuxième plan de référence.

Trois vérins suffiraient à définir ce plan, mais il est préférable d'en augmenter le nombre pour limiter une flexion éventuelle de la plaque sensible. Comme on utilise dans l'appareil décrit des plaques carrées, on a fixé dans cet exemple de réalisation le nombre de vérins à quatre.

Il est préférable de fixer la position d'appui de ces vérins sur le pourtour de la plaque pour limiter les conséquences d'une détérioration éventuelle de la couche sensible. Dans le cas d'un appareil comme celui décrit qui permet d'utiliser plusieurs dimensions de plaques on utilise donc plusieurs ensembles de vérins disposés selon des couronnes concentriques autour de l'objectif 106. On sélectionne l'un de ces ensembles selon les dimensions de la plaque utilisée.

On a représenté sur la figure 3 une vue en coupe partielle de l'un de ces vérins. La monture 201 comprend une plaque inférieure 301 et une plaque supérieure 302. Une cavité 303 creusée dans la plaque 302 forme un cylindre dans lequel coulisse un piston 304 muni d'un joint 305. Cette cavité est mise en pression à l'aide d'un tuyau 306. Le piston est muni d'une tige de poussée 307 qui coulisse dans un alésage percé dans la plaque 301. Un ressort de rappel 308 repousse le piston vers le haut.

Dans les faits, les débattements utilisés sont très faibles et bien moindres que ceux représentés sur le dessin pour la clarté de ceux-ci. Typiquement la course du piston est de 0,5 mm et la tige 307 saille du plan inférieur de la plaque 301 de 40 µm en position sortie. Ceci permet d'utiliser des adjustements très serrés qui servent, conjointement avec un usinage très précis, à obtenir la précision désirée.

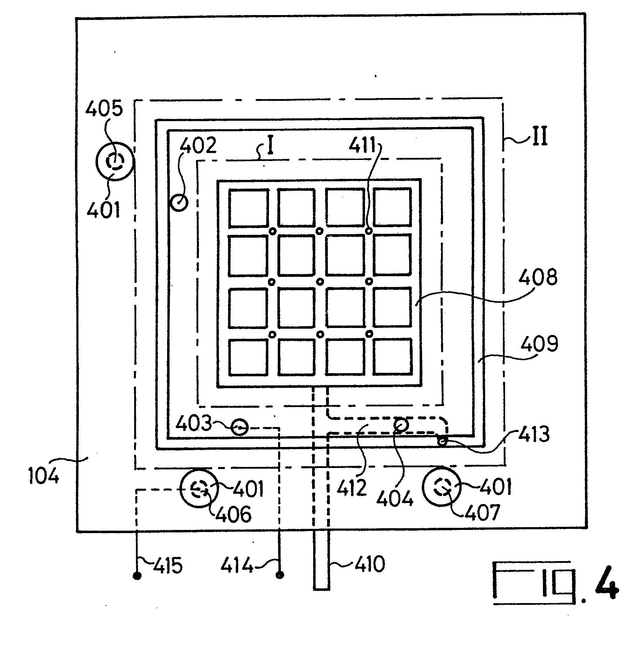

On a représenté en figure 4 une vue en plan de la table 104 dans le cas d'une réalisation permettant d'utiliser plusieurs dimensions de plaques. Les emplacements occupés par ces plaques sont représentés par les traits mixtes I et II. Afin de positionner les plaques sur la table on utilise un jeu trois plots 401 en forme de punaises pouvant être placés dans des trous. Un premier jeu de trous 402 à 404 définit l'emplacement I et un deuxième jeu de trous 405 à 407 définit l'emplacement II. pour maintenir les plaques sur la table on utilise un système d'aspiration à l'aide d'un réseau de rainures entrecroisées 408 sous l'emplacement I et d'une rainure périphérique 409 sous l'emplacement II. Un tuyau de mise en dépression 410 permet d'aspirer l'air dans une cavité creusée sous les rainures 408 et qui communique avec celles-ci par l'intermédiaire d'une série de trous 411. Une canalisation dérivée 412 permet d'aspirer l'air dans la rainure 410 par l'intermédiaire du trou 413. Le trou de positionnement 404 débouche dans la canalisation 412 et lorsque les plots 401 délimitent l'emplacement I, l'un de ceux-ci est enfoncé dans le trou 404 et bouche cette canalisation 412. On évite ainsi de perturber l'aspiration lors de la mise à l'air libre de la rainure 409. On a également disposé au fond des trous 403 et 406 des contacts électriques isolés et reliés respectivement aux fils de connexion 414 et 415. Ainsi le plot qui est placé soit dans le trou 403, soit dans le trou 404, établit une connexion entre la table 104 et l'un des fils 414 et 415, ce qui permet d'indiquer à l'appareillage de commande 107 la taille de la plaque utilisée. Un même plot peut d'ailleurs à la fois boucher la canalisation et établir le contact voulu, pour remplir les deux mêmes fonctions.

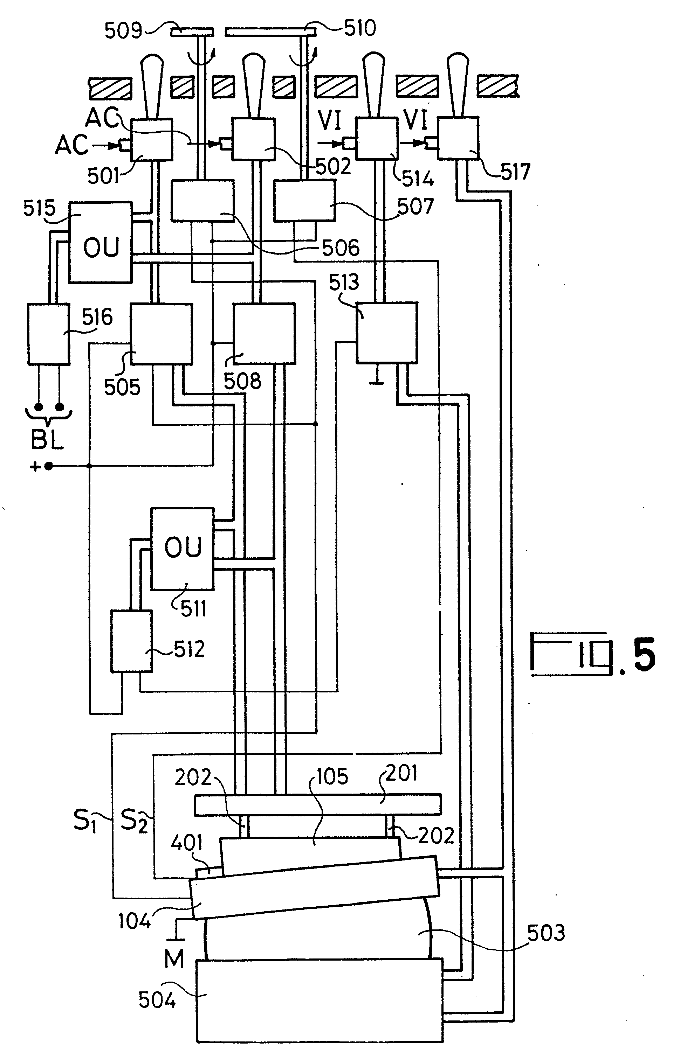

Le schéma de l'ensemble logique fluidique et électrique qui permet de contrôler le positionnement de la table est représenté en figure 5 dans le cas d'un appareil permettant d'utiliser deux dimensions de plaques. Deux vannes pneumatiques manuelles permettent de faire manoeuvrer chacun un jeu de vérins correspondant à une dimension de plaque. Sur la figure on voit deux vérins 202 d'un de ces jeux en position sortie de la monture d'objectif 201 et venant s'appuyer sur une plaque sensible 105 portée par une table 104 fixée à une rotule comprenant un piston sphérique 503 et un socle 504.

La plaque 105 est positionnée sur la table 104 par des plots 401 dont un seul est représenté. Celui-ci établit en outre une connexion électrique entre la masse M et un circuit $S_1$. Pour l'autre dimension de plaque cette connexion se ferait entre M et $S_2$.

Cette connexion permet d'ouvrir une électro-vanne 505 et de faire tourner un électro-aimant rotatif 506, tous deux étant d'autre part connectés à une source de tension +. L'autre dimension de plaque correspond à l'électro-vanne 508 et à l'électro-aimant 507.

L'électro-aimant 506 découvre ainsi la vanne 501 en faisant tourner un volet de masquage 509 qui constitue à la fois une signalisation et une sécurité empêchant de commander la vanne quand une plaque de l'autre dimension est fixée sur la table. L'électro-aimant 507 ne fonctionnant pas masque alors la vanne 502.

Les vannes 501 et 502 sont alimentées par un réseau d'air comprimé AC. En actionnant la vanne 501 démasquée par le volet 509, cet air comprimé passe par l'électro-vanne 505 qui est ouverte comme on l'a vu plus haut et aboutit au jeu de vérins 202 qui sortent de la monture 201.

Les sorties des vannes 505 et 508 sont aussi branchées à un circuit fluidique OU 511 dont la sortie est branchée à un mano-contact 512. Ainsi, quand un jeu de vérins est sorti, ce mano-contact se ferme et applique la tension + sur une troisième électro-vanne 513 qui s'ouvre.

On peut alors agir sur une vanne manuelle 514 branchée à un réseau de vide VI. En ouvrant cette vanne on fait fonctionner par l'intermédiaire de l'électro-vanne 513 un dispositif contenu dans le socle 504 qui fait monter le piston 503, ce qui applique la plaque 105 sur les vérins 202.

Ainsi, on ne peut faire monter le piston que si les vérins sont sortis et si on les fait rentrer le mouvement ascendant du piston cesse.

Un autre circuit fluidique OU 515 est branché sur les sorties des vannes 501 et 502, et la sortie de ce circuit est branchée sur un mano-contact 516. Celui-ci ferme un circuit électrique BL quand l'une des vannes 501 OU 502 est ouverte. Ce circuit BL est appliqué au dispositif extérieur 103 non représenté sur la figure et qui sert à déplacer la rotule sur la table 101 de la figure 1. L'état fermé du circuit sert à inhiber le fonctionnement du dispositif de déplacement, ce qui permet de ne pas rayer la plaque 105 par les vérins 202 à cause d'un déplacement intempestif de celle-ci.

Lorsque la plaque est imobilisée contre les vérins, on manoeuvre une vanne manuelle 517 branchée sur le réseau de vide. En ouvrant cette vanne on fait fonctionner un dispositif de blocage contenu dans le socle 504 et qui bloque le piston 503 dans ce socle en empêchant tout mouvement relatif de ces deux pièces. On aspire en même temps l'air contenu dans les rainures de la table 104 et la pression atmosphérique immobilise la plaque 105 sur cette table.

La surface sensible de la plaque est ainsi placée et maintenue dans le deuxième plan de référence, comme désiré. On peut alors en actionnant la vanne 501 faire remonter les vérins dans la monture de l'objectif. Ce faisant, le mano-contact 516 ouvre le circuit BL et le dispositif de déplacement peut fonctionner librement. Le disositif de manoeuvre du piston n'est alors plus actionné, mais le dispositif de blocage empêche tout mouvement du piston.

On peut alors procéder à l'impression de la surface sensible de la plaque.


**Revendications**

1. Système optique de projection muni d'un positionneur de plaque, du type comprenant une rotule réglable en hauteur et en assiette et destinée à supporter une plaque comprenant une face libre à positionner dans un plan de référence, un objectif définissant ce plan de référence, et des moyens permettant de commander les mouvements de la rotule, caractérisé en ce qu'il comprend en outre au moins un ensemble de vérins extensibles solidaires de l'objectif et dont les extrémités se placent dans le plane de référence en position sortie des vérins; les moyens de commande permettant de plaquer la face libre de la plaque contre les extrémités sorties des vérins puis d'immobiliser la rotule dans la position ainsi déterminée.

2. Système optique selon la revendication 1, caractérisé en ce que la rotule supporte une table destinée à recevoir la plaque et munie de moyens à dépression permettant d'immobiliser la plaque et d'au moins deux ensembles de trous destinés à recevoir un ensemble de plots permettant de positionner la plaque sur la table; les plots étant placés dans l'ensemble de trous correspondant aux dimensions de la plaque et l'un au moins de ces plots permettant de boucher une canalisation de dépression pour mettre hors service une partie des moyens à dépression selon les dimensions de la plaque.

3. Système optique selon la revendication 2, caractérisé en ce qu'un trou de chaque ensemble de trous est muni d'un contact électrique destiné à être actionné par le plot placé dans ce trou; ce contact faisant partie d'un circuit électrique relié aux moyens de commande et permettant d'indiquer à ceux-ci les dimensions de la plaque utilisée.

4. Système optique selon l'une quelconque des revendications 1 à 3, caractérisé en ce que les moyens de commande comprennent des premiers moyens permettant d'actionner la rotule, des seconds moyens permettant de sortir les vérins, et des troisièmes moyens permettant d'interdire le fonctionnement des premiers moyens lorsque les vérins sont rétractés.

5. Système optique selon l'une quelconque des revendications 3 et 4, caractérisé en ce qu'il comprend autant d'ensembles de vérins que d'ensembles de trous, et que les moyens de commande comprennent des vannes manuelles correspondant aux dimensions de plaque définies par les ensembles de trous et les ensembles de vérins, et des volets mobiles masquant les accès de ces vannes; chaque volet pouvant se déplacer sous la commande du circuit électrique actionné par le plot inséré dans le trou muni d'un contact de l'ensemble de trous correspondant à la vanne à découvrir.


**Claims**

1. Optical projection system provided with plate positioning means of the type comprising a ball-joint adjustable in height and trim and adapted to support a plate comprising a free surface to be positioned in a reference plane, object lens means defining said reference plane, and means adapted to control the movements of the ball-joint, characterized in that it further comprises at least one group of extensible jacks integral with said object lens means, the ends of said jacks being located in said reference plane when said jacks are in the extended position, said control means being adapted to allow said free surface of the plate to be pressed against the extended ends of the jacks and then to lock said ball-joint in the thus determined position.

2. Optical system according to claim 1, characterized in that the ball-joint supports a table adapted to receive said plate and provided with vacuum-producing means allowing said plate to be locked in its position, and with at least two groups of holes adapted to receive a group of stoppers allowing said plate to be positioned on the table, said stoppers being placed in the group of holes corresponding to the dimensions of the plate, and at least one of said stoppers being adapted to seal a vacuum conduit so as to render ineffective a portion of the vacuum-producing means, depending on the dimensions of the plate.

3. Optical system according to claim 2, characterized in that one hole of each group of holes is provided with an electric contact adapted to be actuated by the stopper placed in said hole, said contact being part of an electric circuit connected to said control means, and being adapted to indicate to the latter the dimensions of the plate being used.

4. Optical system according to any one of claims 1 to 3, characterized in that said control means comprise first means adapted to actuate said ball-joint, second means adapted to extend said jacks, and third means adapted to inhibit the operation of said first means when said jacks are retracted.

5. Optical system according to any one of claims 3 and 4, characterized in that the number of groups of jacks is equal to the number of groups of holes, and that in said control means comprise manually controlled valves corresponding to the dimensions of the plate, as defined by the groups of holes and the groups of jacks, said system further comprising movable shutters adapted to mask the inlets of said valves, each shutter being adapted to be moved by the action of the electric circuit actuated by the stopper introduced into that hole of the group of holes corresponding to the valve to be opened, which is provided with a contact.

**Patentansprüche**

1. Optische Projektionseinrichtung mit einem Platteneinsteller, bei der ein höhenverstellbares und trimmeinstellbares Kugelgelenk zum Stützen einer Platte vorgesehen ist, welche eine in eine durch ein Objectiv definierte Bezugsebene bringbare freie Oberfläche aufweist, sowie mit die Bewegungen des Kugelgelenks steuernden Steuermitteln, dadurch gekennzeichnet, dass die Projecktionseinrichtung ferner wenigstens eine mit dem Objectiv fest verbundene Gruppe ausfahrbarer Presstöpfe aufweist, deren Enden in der Ausfahrstellung der Presstöpfe in der Bezugsebene liegen, wobei die Steuermittel es gestatten, die freie Oberfläche der Platte an die ausgefahrenen Enden der Presstöpfe anzudrücken und sodann das Kugelgelenk in der auf diese Weise definierten Lage festzulegen.

2. Optische Einrichtung nach Anspruch 1, dadurch gekennzeichnet, dass das Kugelgelenk eine zur Aufnahme der Platte bestimmte Tafel aufweist welche Unterdruckmittel zum Festlegen der Platte, sowie wenigstens zwei Lochgruppen zur Aufnahme einer Mehrzahl von das Ausrichten der Platte auf der Tafel ermöglichenden Stöpsel besitzt, wobei die Stöpsel in die den Abmessungen der Platten entsprechende Lochgruppe einsteckbar sind und vermittels wenigstens eines der Stöpsel eine Unterdruckleitung verschliessbar ist, um nach Massgabe der Plattenabmessungen einen Teil der Unterdruckmittel unwirksam zu machen.

3. Optische Einrichtung nach Anspruch 2, dadurch gekennzeichnet, das ein Loch jeder Lochgruppe einen durch den in dieses Loch eingesteckten Stöpsel betätigbaren elektrischen Kontakt aufweist, der einer an die Steuermittel angeschlossenen elektrischen Schaltung zugeordnet ist, welche den Steuermitteln die Abmessungen der verwendeten Platte angibt.

4. Optische Einrichtung nach einem der Ansprüche 1 bis 3, dadurch gekennzeichnet, dass die Steuermittel erste Mittel zur Betätigung des Kugelgelenks, zweite Mittel zum Aufahren der Presstöpfe, sowie dritte Mittel aufweisen, welche die Betätigung der ersten Mittel verhindern, wenn die Presstöpfe eingefahren sind.

5. Optische Einrichtung nach einem der Ansprüche 3 und 4, dadurch gekennzeichnet, dass sie ebensoviel Presstopfgruppen wie Lochgruppen aufweist, und dass die Steuermittel den von den Lochgruppen und den Presstopfgruppen definierten Plattenabmessungen entsprechende handgesteuerte Ventile, sowie bewegliche, den Einlass dieser Ventile abdeckende Kalppen aufweisen, wobei die Bewegungen jeder Klappe durch die elektrische Schaltung gesteuert werden, welche von dem in das mit einem Kontakt versehene Loch der dem zu öffnenden Ventil entsprechenden Lochgruppe eingesteckten Stöpsel betätigt wird.

107

106

M

105

104

101

103

102

Fig.1

Fig. 2

Fig. 3

FIG. 4

0 006 787

Fig.5